**Europäisches Patentamt**

**European Patent Office**

**Office européen des brevets**

(19)

(11) Publication number: **0 076 129**
**A2**

(12) # EUROPEAN PATENT APPLICATION

(21) Application number: **82305075.2**

(22) Date of filing: **24.09.82**

(51) Int. Cl.³: **H 03 K 7/08**

(30) Priority: **26.09.81 JP 152631/81**

(43) Date of publication of application:
**06.04.83 Bulletin 83/14**

(84) Designated Contracting States:
**DE FR GB**

(71) Applicant: **MITSUBISHI DENKI KABUSHIKI KAISHA**
**2-3, Marunouchi 2-chome Chiyoda-ku**
**Tokyo 100(JP)**

(72) Inventor: **Kazuharu, Nishitani**
**Kita-Itami Works No. 1 Mizuhara 4-chome**
**Itami-shi, Hyogo(JP)**

(74) Representative: **Prutton, Roger et al,**
**Marks & Clerk Alpha Tower Suffolk Street Queensway**
**Birmingham B1 1TT(GB)**

(54) **Circuit for generating pulse waveforms with variable duty cycles.**

(57) A circuit for generating pulse waveforms having variable duty cycles including a counter (11) which counts machine cycles (each of which includes a plurality of pulse intervals) and clears to zero when the count reaches a first prescribed value. A plurality of registers (12A, 12B, 12C) store data corresponding to the required duty cycles of a like plurality of output pulse waveforms, and a single comparator (13) compares the count with the contents of these registers in different ones of the pulse intervals of each machine cycle. A plurality of output flip-flops (17A, 17B, 17C) are connected to be controlled by the counter and the comparator so that each is reset in the appropriate pulse interval of a machine cycle in which the count reaches the content of the associated register and set in the appropriate pulse interval after the counter is cleared to zero.

FIG.3.

The present invention relates to a circuit for generating pulse waveforms having a constant period of repetition and a variable duty cycle.

As digital integrated circuit devices become smaller in size and less costly, they have found more usage as circuits for generating a pulse waveform with a variable duty cycle to produce a voltage that can be used for adjusting the volume of sound, hue, brightness and the like of television receivers, for example.

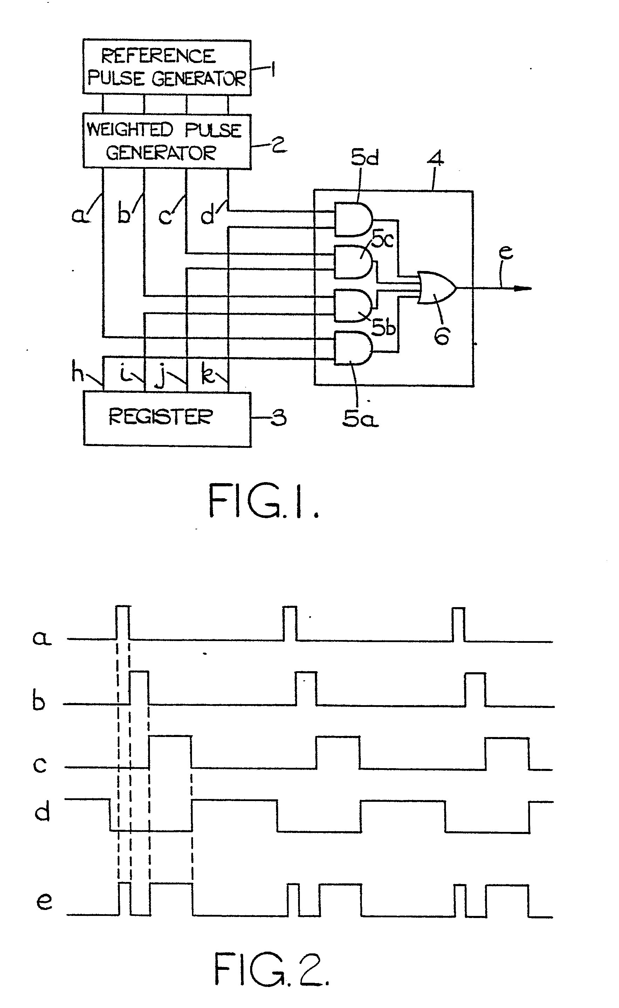

Fig. 1 is a block diagram of a conventional circuit for generating a train of pulses having a variable duty cycle. The circuit comprises a reference pulse generator 1, a weighted-pulse generator 2 operable in synchronism with reference pulses from the reference pulse generator 1 for producing a pulse output a having a duty cycle of 1/16, a pulse output b having a duty cycle of 1/8, a pulse output c having a duty cycle of 1/4, and a pulse output having a duty cycle of 1/2, and a register 3 for holding and issuing 4-bit information h, i, j and k to determine a combination of the pulse outputs a, b, c and d which gives rise to an output waveform having a desired duty cycle. The pulse generator circuit also includes a pulse synthesizer 4 for combining the pulse outputs a, b, c and d dependent on the output from the register 3 to produce an output waveform of a desired duty cycle. The pulse synthesizer 4 is composed of AND gates 5a, 5b, 5c and 5d for ANDing the pulse output a and the bit information output h, the pulse output b and the bit information output i, the pulse output c and the bit information ouput j, and the pulse output d and the bit information output k, respectively, and an OR gate 6 for ORing outputs from the AND gates 5a, 5b, 5c and 5d.

Fig. 2 is a waveform diagram illustrative of operation of the prior pulse generator circuit shown in Fig. 1. The four pulse outputs a, b, c and d have pulses which are shifted in phase so as not to overlap one another. In Fig. 2, the 4-bit information set in the register 3 is composed of bits "1", "0", "1", "0" in order successively from the least significant bit, that is, h = "1", i = "0", j = "1" and k = "0". Therefore, only the AND gates 5a, .5c are open to pass the pulse outputs A and C, respectively, that are combined by the OR gate 6 from which the pulsed output e having a duty cycle of 5/16 as shown in Fig. 2. The output from the OR gate 6 is then passed through a low-pass filter, if necessary, so that it can be utilized to adjust the sound volume, hue, brightness or the like of television receivers.

The conventional circuit arrangement is however disadvantageous in that it requires as many registers and pulse synthesizers as there are pulsed outputs of variable duty cycles to be generated, resulting in an enlarged pattern size and an increased cost when the circuit is to be fabricated as an integrated circuit.

In view of the foregoing difficulties, it is an object of the present invention to provide a circuit of a simple construction for generating a plurality of pulsed outputs having variable duty cycles by comparing the contents of a plurality of registers which determine duty cycles with the content of a counter which counts pulses in each machine cycle on a time-sharing basis during each machine cycle.

Accordingly, the invention provides a circuit for generating pulse waveforms having variable duty cycles, comprising a counter for counting pulses in machine cycles repeatable at a predetermined period, each machine cycle being composed of a plurality of pulse intervals, said counter being arranged to count the pulses one by one in the first pulse interval in each machine cycle and to be cleared to zero when the count by the counter reaches a first prescribed value, a plurality of registers for storing data corresponding respectively to a plurality of pulse waveforms to be generated and for being supplied with numerical values smaller than said first prescribed value, a comparator for comparing the data in each of said registers with the count in said counter on a time-sharing basis successively in the pulse intervals following said first pulse interval in each machine cycle and for generating an output upon coincidence between said data and count, and a plurality of flip-flops provided respectively for the pulse waveforms to be generated, said flip-flops being settable in each of said pulse intervals following said first pulse interval in each machine cycle when the count in the counter reaches a second prescribed value and resettable by said output from said comparator.

In the accompanying drawings:-

Fig. 1 is a block diagram of a conventional circuit for generating a pulse waveform having a variable duty cycle;

Fig. 2 is a waveform diagram illustrative of operation of the circuit shown in Fig. 1;

Fig. 3 is a block diagram of a circuit for generating pulse waveforms having variable duty cycle according to an embodiment of the present invention; and

Fig. 4 is a waveform diagram showing operation of the circuit illustrated in Fig. 3.

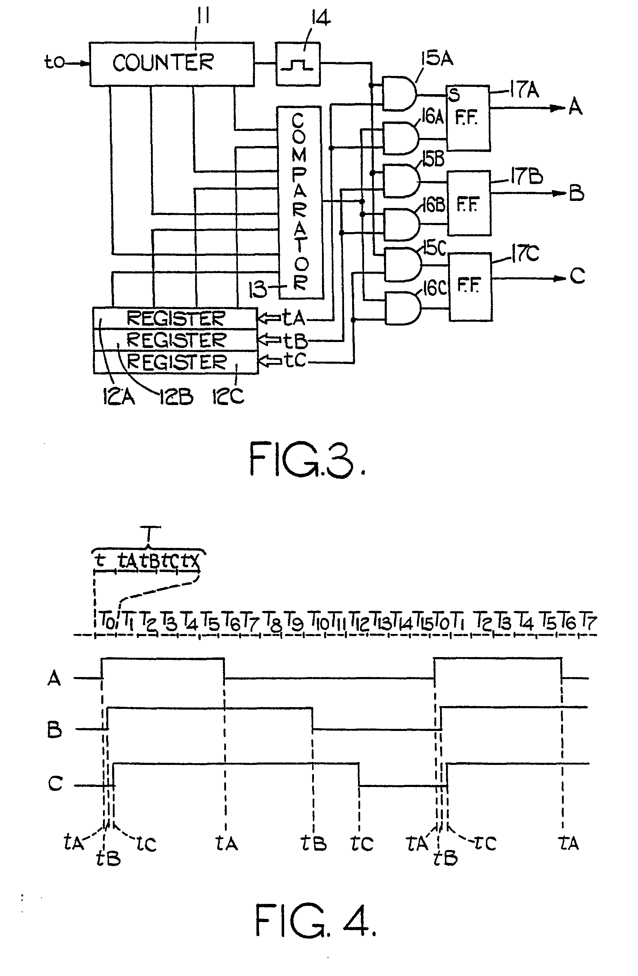

In the illustrated embodiment, the circuit generates three ouputs of variable duty cycles by operating under timing control (no control unit shown) with one machine cycle indicated as T (Fig. 4) and composed of five pulses time intervals of $t_0$, $t_A$, $t_B$, $t_C$ and $t_X$.

The circuit illustrated in Fig. 3 comprises a 4-bit binary counter 11 for counting timing pulses $t_0$, registers 12A, 12B and 12C supplied with 4-bit information data which designate different output duty cycles, a comparator 13 for comparing the 4-bit count by counter 11 with the 4-bit data held in the register 12A, 12B or 12C and for generating an output upon coincidence of the input data, and a pulse-leading-edge detector 14 for generating an output when the count by the counter 11 reaches a predetermined level (the condition of all the 4 bits being "0" in the illustrated embodiment). The circuit of Fig. 3 also includes AND gates 15A, 15B and 15C for ANDing and output from the pulse-leading-edge detector 14 and the timing pulses $t_A$, $t_B$ and $t_C$, AND gates 16A, 16B and 16C for ANDing an output from the comparator 13 and the timing pulses $t_A$, $t_B$ and $t_C$, a first flip-flop 17A settable by an output from the AND gate 15A and resettable by an output from the AND gate 16A for producing a first output A of a variable duty cycle, a second flip-flop 17B settable by an output from the AND gate 15B and resettable by an output from the AND gate 16B for producing a second output B of a variable duty cycle, and a third flip-flop 17C settable by an output from the AND gate 15C and resettable by an output from the AND gate 16C for producing a third output C of a variable duty cycle.

As shown in Fig. 4, the first output A from the first flip-flop 17A has a duty cycle of 6/16, the second output B from the second flip-flop 17B has a duty cycle 10/16, and the third output C from the third flip-flop 17C has a duty cycle of 12/16. The registers 12A, 12B and 12C hold binary information "0110", "1010" and "1100", respectively, which are delivered to the comparator 13 only during the pulse intervals $t_A$, $t_B$ and $t_C$, respectively.

When the counter 11 starts with "0000", this count data is detected by the pulse-leading-edge detector 14 and set into the first, second and third flip-flops 17A, 17B and 17C through the AND gates 15A, 15B and 15C, respectively, in the pulse intervals $t_A$, $t_B$ and $t_C$ in the machine cycle $T_0$. As the operation goes through machine cycles $T_1$, $T_2$, $T_3$,..., the counter 11 counts up pulses in each pulse interval $t_0$, and the count by the counter 11 becomes "0110" in the pulse interval $t_0$ in the machine cycle $T_6$. The comparator 13 detects coincidence between the content of the counter 11 and the content of the register 12A in the pulse interval $t_A$ in the machine cycle $T_6$, and resets the first flip-flop 17A via the AND gate 16A, whereupon the first flip-flop 17A produces the output A as shown in Fig. 4. Likewise, the comparator 13 resets the second flip-flop 17B in the pulse interval $t_B$ in the machine cycle $T_{10}$, so that the second flip-flop 17B issues the output B as shown in Fig. 4. The third flip-flop 17C is reset by the comparator 13 in the pulse interval $t_C$ in the machine cycle $T_{12}$ and produces the output C as illustrated in Fig. 4. The count by the counter 11 is cleared to "0000" in the next machine cycle $T_0$, and then the above operation is repeated again.

When the duty cycle of each output is to be changed, the data in the corresponding register should be altered such as by resorting to the pulse interval $t_X$.

While in the foregoing embodiment three outputs of variable duty cycles are produced, registers, AND gates and flip-flops may be added to increase the number of pulse intervals in each machine cycle so that four or more outputs can be generated. The duty cycles, which have been shown as being available in 16 steps, may be provided in increased steps by increasing the number of bits in the counter, registers and comparator. The operation of the comparator may be effected by utilizing an arithmetic circuit in a microcomputer.

With the arrangement of the present invention, as described above, the circuit for generating pulse waveforms of variable duty cycle compares the contents of the registers which determine duty cycles with the count by the counter which counts pulses in the machine cycles on a time-sharing basis in each machine cycle. The circuit of the invention is thus composed of a simple comparator arrangement for producing a plurality of outputs having variable duty cycles.

## CLAIMS

1. A circuit for generating pulse waveforms having variable duty cycles, comprising a counter for counting pulses in machine cycles repeatable at a predetermined period, each machine cycle being composed of a plurality of pulse intervals, said counter being arranged to count the pulses one by one in the first pulse interval in each machine cycle and to be cleared to zero when the count by the counter reaches a first prescribed value, a plurality of registers for storing data corresponding respectively to a plurality of pulse waveforms to be generated and for being supplied with numerical values smaller than said first prescribed value, a comparator for comparing the data in each of said registers with the count in said counter on a time-sharing basis successively in the pulse intervals following said first pulse interval in each machine cycle and for generating an output upon coincidence between said data and count, and a plurality of flip-flops provided respectively for the pulse waveforms to be generated, said flip-flops being settable in each of said pulse intervals following said first pulse interval in each machine cycle when the count in the counter reaches a second prescribed value and resettable by said output from said comparator.

2. A circuit according to claim 1, wherein said second prescribed value is zero.

3. A circuit according to claim 1 or 2, wherein said comparator is a microcomputer.

FIG.1.

FIG.2.

2/2

FIG.3.

FIG. 4.